# EUROPEAN PATENT SPECIFICATION

(11) **EP 1 788 638 B1**
(45) Date of publication and mention of the grant of the patent: **14.04.2010**
(21) Application number: 06123479.5
(22) Date of filing: 03.11.2006
(51) Int. Cl.: H01L 31/18

(54) **Apparatus for the production of thin silicon photovoltaic cells and electronic circuits made of rigid and flexible material**
Vorrichtung zur Herstellung von dünnen photovoltaischen Zellen und elektronischen Schaltungen aus flexiblem oder steifem Material
Appareil pour la production de cellules photovoltaiques à couches minces et de circuits électroniques en matériaux rigide et flexible

(30) Priority: 17.11.2005 IT UD20050196
(43) Date of publication of application: 23.05.2007
(73) Proprietor: AFCO C.V., 1876 AZ Amsterdam (NL)
(72) Inventor: Baccini, Gisulfo, 31030 Mignagola di Carbonera (TV) (IT)
(74) Representative: Petraz, Gilberto Luigi

(56) References cited:
- WO-A-92/08245
- WO-A-2004/100252
- DE-A1- 3 238 187
- JP-A- 59 115 569
- US-A- 4 635 788
- US-A- 4 685 608

## Description

### FIELD OF THE INVENTION

The present invention concerns an apparatus for the production of silicon photovoltaic cells and of electronic circuits, each made on one or more very thin layers, even less than 100 µm, of insulating material, on which the conductor tracks are printed that define the lay-out of the photovoltaic cells or circuits. To be more exact, the present invention concerns the transport means that moves the layer or layers between the various work units, that is, the printing, drying, cooling units or other.

### BACKGROUND OF THE INVENTION

Apparatuses are known for the production of photovoltaic cells and electronic circuits made of rigid and flexible material, each made of one or more layers of insulating material, such as a silicon wafer, sintered aluminum, crude or flexible aluminum, or other, on which the conductor tracks are printed.

Known apparatuses comprise, in sequence: a unit to load the layers; a printing unit, in which the conductor tracks are printed on the layers; a drier unit, in which the printed conductor tracks are made to dry at a temperature comprised between about 90°C and about 300°C, for a determinate period of time; and a cooling unit in which the photovoltaic cells and the electronic circuits thus produced are cooled and then discharged from the apparatus.

Known apparatuses also comprise a transport means that allows to move the layers, continuously or intermittently, through all the various units.

Known transport means normally consists of different transport elements such as belts, rollers or guides that move step-wise, such as for example those described in the Italian patent IT-B-1.310.555 in the name of the present Applicant.

For example, in the printing unit the belt on which the layer is disposed is made of paper material, so as to exploit its characteristics of porosity and to suck the layer from below in order to keep it stationary with respect to the belt. It is essential, in such apparatuses, to keep the layer absolutely still and positioned with respect to the printing members which deposit the conductor ink which forms the tracks on the layer.

Moreover, in known apparatuses, the printing unit is disposed at the side of the main line of feed of the layers, and a transverse transport means is provided in order to move each layer individually toward the printing unit and, from this, to the feed line, thus increasing the working times.

The paper belt used in the known printing unit is normally wound in a roll and is progressively unrolled to a collection roller, to advance by a determinate distance after every printing operation. However, this known solution has the disadvantage that it entails temporary and programmed interruptions in production, to allow to replace the roll when the belt has been completely used.

In this known solution there is also the disadvantage that the paper material used must be disposed of.

In the drier unit, where temperatures comprised between about 90°C and about 300°C are reached, the transport of the already printed layers is effected by means of transport elements made of material resistant to high temperatures, usually made of metal.

However, the different transport elements used in known apparatuses increase the costs of production, installation and maintenance, and can cause misalignments of the layers during the movements from one work unit to the other, causing breakages and waste.

In the DE-A-32 38 187 it is disclosed a conveyor belt manufacturing system wherein a substrate strip composed of uncured fibrous tissue impregnated with synthetic resin is passed over a first belt conveyor device and is fitted on the latter with the aid of industrial robots and on a second belt conveyor device with solar cell modules in a group array inside a reinforcing edge. The solar cell module groups pass through a curing oven in which the synthetic resin of the substrate strip and sealing adhesive for the solder joints of current cables undergo curing After leaving the curing oven, the solar cell module groups are cut up by a further industrial robot incorporating a water or laser beam device, checked for their efficiency with a bar-type lamp and prepared_for despatch.

In the US-A-4, 635, 788 it is disclosed an endless belt type of conveyor for small flat workpieces (chips) which provides a series of pockets on a perforate belt, each pocket adapted to support a chip during conveyance through a zone wherein high velocity air jets are directed against the chip. The pockets are formed by facing pairs of series of "H" or "I" shaped crossbars connected between a spaced-apart pair of roller chains. The perforate belt is formed by a Teflon® coated fiberglass screen or silicon rubber, supported by the H crossbars.

In WO-A-2004/100252 it is disclosed an apparatus for separating elongated semiconductor strips from a wafer of semiconductor material wherein vacuum is applied to the face of each semiconductor strip forming an edge of the wafer or being adjacent to the edge. The wafer and the source of the vacuum are displaced to separate each elongated semiconductor strip from the wafer.

One purpose of the present invention is to achieve an apparatus for the production of photovoltaic cells and electronic circuits which has lower costs of production, installation and maintenance than known apparatuses, and which allows to transport the layers at least through the printing unit and through the drier unit without needing to use different transport elements.

Another purpose of the present invention is to achieve an apparatus that does not require programmed interruptions to the production due to the frequent replacement of the transport elements.

Another purpose of the present invention is to achieve an apparatus in which the printing unit is disposed aligned with the line of feed, and hence without needing to move the layers transversely to the latter.

The Applicant has devised, tested and embodied the present invention to overcome the shortcomings of the state of the art and to obtain these and other purposes and advantages.

### SUMMARY OF THE INVENTION

The present invention is set forth and characterized in the main claim, while the dependent claims describe other characteristics of the invention or variants to the main inventive idea.

In accordance with the above purposes, an apparatus for the production of photovoltaic cells, advantageously thin and made of silicon, and of electronic circuits made of rigid and flexible material according to the present invention, comprises at least a printing unit able to print conductor tracks on each layer, a drier unit able to dry said conductor tracks at a determined drying temperature, in order to define the photovoltaic cells or the electronic circuit, and transport means able to transport the layers at least through said printing unit and drier unit.

According to a characteristic feature of the present invention, the transport means comprises a conveyor belt disposed in correspondence with said printing unit and drier unit, and made of porous material having a heat resistance equal to or higher than the drying temperature, so as not to be subjected to permanent deformations.

The porous material of which the conveyor belt is made has a heat resistance comprised between about 90°C and about 300°C.

Advantageously, the conveyor belt is made of multilayer synthetic materials.

In a preferential form of embodiment, the multilayer porous material comprises at least a first inner reinforcement layer and two outer covering layers.

The inner layer is advantageously made of fibrous fabric, for example with a silicon base, such as fiber glass or suchlike, or with a polyamide organic base with an aromatic chain, such as Kevlar®, or similar materials, while each outer layer is made of a polymer with a fluorocarbon base, such as for example polytetrafluoroethylene (PTFE).

According to a variant, along both lateral edges of the conveyor belt respective reinforcement and guide elements are provided, made of resistant organic material and able to stiffen the conveyor belt and to guide it in correspondence with the various operating units.

In this way, even with the same conveyor belt, it is possible to move the layers both through the printing unit, consisting for example of a serigraphy or ink jet station, and also through the drier unit, consisting for example of a drier oven, without varying the normal working conditions of the two units.

In fact, the multilayer porous material which makes up the conveyor belt allows, in the printing unit, suction through the belt itself so as to maintain, in a known manner, each layer adherent to it, and, in the drier unit, is resistant to the drying temperatures.

Moreover, the conveyor belt according to the invention has structural characteristics such as to be able to be disposed, closed in a ring, around two movement pulleys, and not wound in a roll around rollers, as happens instead with the paper belts in the state of the art.

In this way we also obtain the considerable advantage of having the printing unit aligned with the drier unit, considerably reducing the working times, since it is no longer necessary to move each layer transversely in order to take it from the feed line to the printing unit and vice versa, as happens in the state of the art.

With the solution according to the present invention it is therefore possible to work substantially continuously, that is, without programmed interruptions to the production in order to replace the rolls of the belt.

Advantageously, at least in correspondence with the printing unit, a supporting suction plane is provided disposed in association with the conveyor belt, and able to keep the latter substantially plane and to effect suction through it, in order to keep the layers perfectly adherent to an outer surface of the conveyor belt.

### BRIEF DESCRIPTION OF THE DRAWINGS

These and other characteristics of the present invention will become apparent from the following description of a preferential form of embodiment, given as a non-restrictive example with reference to the attached drawings wherein:
- - fig. 1: is a schematic three-dimensional view of an apparatus for the production of photovoltaic cells and electronic circuits according to the present invention;
- - fig. 2: is a cross section along the line from II to II in fig. 1 of a conveyor belt, in a first form of embodiment;
- - fig. 3: is a cross section along the line from II to II in fig. 1 of a conveyor belt, in a second form of embodiment;
- - fig. 4: is a cross section along the line from II to II in fig. 1 of a conveyor belt, in a third form of embodiment;
- - fig. 5: is an enlarged view of a detail of fig. 2.

### DETAILED DESCRIPTION OF A PREFERENTIAL FORM OF EMBODIMENT

With reference to the attached drawings, an apparatus 10 for the production of photovoltaic cells, thin and made of silicon, and electronic circuits made of rigid and flexible material according to the present invention comprises, disposed aligned with each other, a loading unit 11 in which the layers 12 to be sent to the production process are placed, a printing unit 13 in which the conductor tracks 15 are printed on each layer 12 so as to define the photovoltaic cells or the electronic circuit, a drier unit 14 in which the conductor tracks 15 are dried and then consolidated, and a cooling unit 16, in which the electronic circuits thus made are cooled to be sent to subsequent operating steps, or storage.

Each layer 12 consists for example of one or more flexible, very thin sheets, in the order to about 100 µm, of insulating material, for example silicon wafer, sintered aluminum, crude or flexible aluminum, or other

The apparatus 10 according to the invention also comprises a single conveyor belt 17 able to transport the layers 12 in sequence through said units 11, 13, 14 and 16, to achieve the photovoltaic cells or electronic circuits.

The conveyor belt 17 is substantially disposed around a driven pulley 18, provided in correspondence with the loading unit 11, and a motorized pulley 19, provided downstream of the cooling unit 16. A plurality of belt-tensioning pulleys 20 are also associated with the conveyor belt 17, which allow to keep the conveyor belt 17 at a desired working tension.

According to a characteristic of the present invention, the conveyor belt 17 is made of multilayer porous material, so that, in correspondence with the printing unit 13, it allows the passage of air through its thickness and, in correspondence with the drier unit 14, it resists high working temperatures, comprised for example between about 90°C and about 300°C.

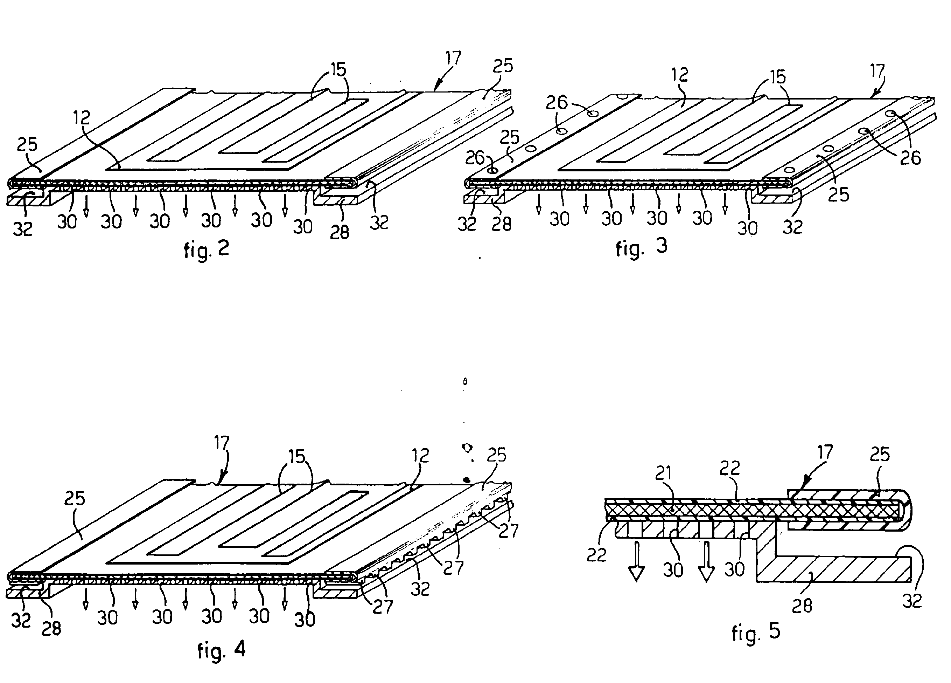

To be more exact, the multilayer porous material consists of an inner reinforcement layer 21 (fig. 5) made of a fibrous fabric, for example fiber glass, polyamide organic fiber with an aromatic chain (Kevlar®) or suchlike, and two outer layers 22, each made with a polymer material with a fluorocarbon base, such as polytetrafluoroethylene (Teflon®) for example, or similar materials.

Moreover, along both lateral edges of the conveyor belt 17 respective reinforcement laminas are provided, made of resistant organic material, for example Kevlar®, and able to stiffen the conveyor belt 17 and guide its passage in correspondence with the various units 11, 13, 14 and 16.

In the form of embodiment shown in fig. 2, the reinforcement laminas 25 each consist of a sheet of bent Kevlar®, disposed astride the respective edge of the conveyor belt 17 and hot welded with its opposite edges to the two outer layers 22.

Alternatively, as shown in the form of embodiment in fig. 3, the Kevlar® sheet, bent, is attached to the conveyor belt 17 by means of a plurality of studs 26, disposed through, both through its edges and also through the two outer layers 22 and the inner layer 21 which make up the conveyor belt 17.

In the form of embodiment shown in fig. 4, one of the two edges of the bent sheet of Kevlar®, in this case the one facing downward, has on the outside a plurality of teeth 27 able to engage with corresponding toothed wheels, of a known type and not shown here, which are able to guide and transmit motion to the conveyor belt 17.

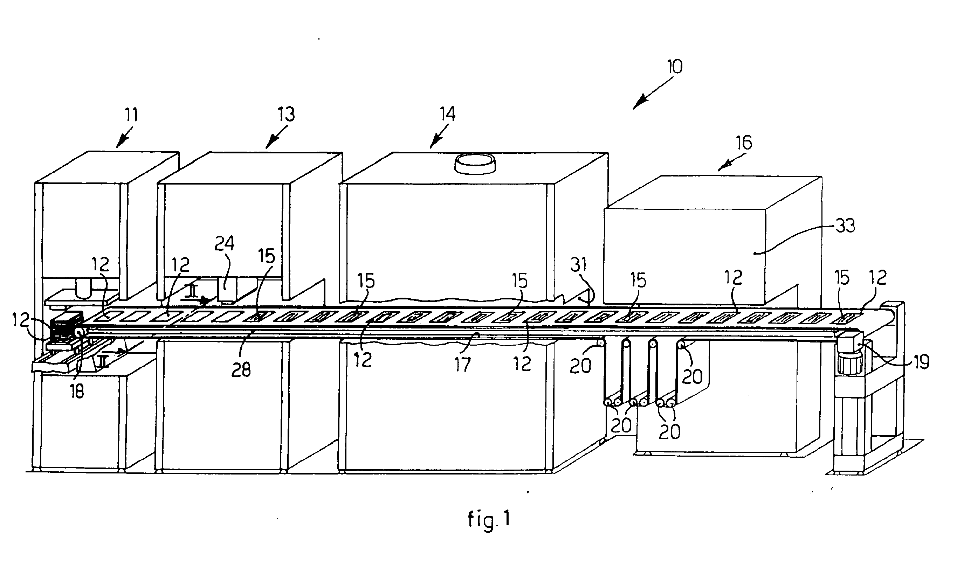

The printing unit 13 (fig. 1) is of a substantially known type and comprises a printing head 24 and a supporting and suction plane 28, disposed in cooperation with the conveyor belt 17. In the case shown here, the supporting and suction plane 28 is disposed so as to keep the conveyor belt 17 substantially plane, in correspondence with the respective work zones of the operating units 11, 13, 14 and 16.

The supporting and suction plane 28 also comprises a plurality of through holes 30, able to effect a suction which, exploiting the porous characteristics of the material that makes up the belt 17, allows to keep the layer 12 perfectly adherent to the outer surface of the conveyor belt 17, thus guaranteeing an optimum positioning of the layer 12 with respect to the printing head 24.

The supporting and suction plane 28 also comprises, at the sides, two guide seatings 32 which, in cooperation with the reinforcement laminas 25, guide the linear sliding of the conveyor belt 17, preventing lateral oscillations thereof.

The drier unit 14 (fig. 1) is also of a substantially known type and comprises a drying chamber 31 in which a temperature comprised between about 90°C and about 300°C is maintained in order to dry the conductor tracks 15 printed on the layers 12, so as to define the photovoltaic cells or the electronic circuits proper.

The cooling unit 16 is also of a substantially known type and comprises an ultra-sound washing unit 33 to clean the working impurities from the photovoltaic cells or the electronic circuits thus made, and to take them to a temperature suitable for the subsequent working steps and/or storage.

It is clear however that modifications and/or additions of parts may be made to the apparatus 10 as described heretofore, without departing from the field and scope of the present invention.

For example, it comes within the field of the present invention to provide a plurality of supporting planes 28, disposed over the whole length of the conveyor belt and able to guarantee, in cooperation with the belt-tensioning pulleys 20, that the belt is substantially co-planar in correspondence with the various units 11, 13, 14 and 16 which make up the apparatus 10.

According to a variant, the supporting planes 28 do not necessarily provide suction through the holes 30, and may consist, according to specific requirements, of transverse beams, longitudinal strips, fixed and cooperating with the lateral strips, frame-type structures or other.

It is also clear that, although the present invention has been described with reference to specific examples, a person of skill in the art shall certainly be able to achieve many other equivalent forms of apparatus for the production of thin silicon photovoltaic cells and electronic circuits made of rigid and flexible material, having the characteristics as set forth in the claims and hence all coming within the field of protection defined thereby.

## Claims

1. Apparatus for the production of photovoltaic cells and of electronic circuits each consisting of at least a layer (12) consisting of one or more flexible, very thin sheets, in the order to about 100 micron, of insulating material, for example silicon wafer, sintered aluminum, crude or flexible aluminum on which conductor tracks (15) are printed, said apparatus comprising at least a printing unit (13) that is disposed aligned with the line of feed and that is able to print said conductor tracks (15) on said layer (12) by means of serigraphy or ink jet printing, a drier unit (14) able to dry said conductor tracks (15) at a determined drying temperature, and transport means (17) able to transport said layer (12) at least through said printing unit (13) and said drier unit (14), **characterized in that** said transport means comprises a single conveyor belt (17) disposed at least in correspondence with said printing unit (13) and said drier unit (14) and able to transport, substantially continuously, the layers (12) in sequence through at least said printing unit (13) and said drier unit (14), without needing to move the layers (12) transversely to the line of feed, to achieve the photovoltaic cells or electronic circuits, the single conveyor belt (17) being made of porous material having a heat resistance equal to or higher than said drying temperature, so as not to be subjected to permanent deformations, **in that** said porous material has a heat resistance comprised between about 90°C and about 300°c and **in that** said porous material consists of a first inner reinforcement layer (21) made of a fibrous fabric, and at least a second outer layer (22) made of a polymer with a fluorocarbon base, wherein the printing unit (13) further comprises a supporting and suction plane (28), disposed in cooperation with the conveyor belt (17), so as to keep the conveyor belt (17) substantially plane, the supporting and suction plane (28) being also provided with a plurality of through holes (30), able to effect a suction which, exploiting the porous characteristics of the material that makes up the conveyor belt (17), allows to keep the layer (12) perfectly adherent to the outer surface of the conveyor belt (17).

2. Apparatus as in claim 1, **characterized in that** said fibrous fabric is at least partly silicon-based.

3. Apparatus as in claim 1 or 2, **characterized in that** said fibrous fabric is at least partly polyamide organic based with an aromatic chain.

4. Apparatus as in any claim hereinbefore, **characterized in that** said polymer with the fluorocarbon base is polytetrafluoroethylene.

5. Apparatus as in any claim hereinbefore, **characterized in that** said conveyor belt (17) is constituted by a single closed ring disposed around a first driven pulley (18) positioned upstream of said printing unit (13), and a second motorized pulley (19) positioned downstream of said drier unit (14).

6. Apparatus as in any claim hereinbefore, **characterized in that** it further comprises a plurality of belt-tensioning pulleys (20) able to keep said conveyor belt (17) at a desired working tension.

7. Apparatus as in any claim hereinbefore, **characterized in that** along both lateral edges of said conveyor belt (17) respective reinforcement elements (25) are provided, made of resistant organic material and able to stiffen said conveyor belt (17) and to guide the passage of said conveyor belt (17) in correspondence with said operating units (11, 13, 14, 16).

8. Apparatus as in claim 7, **characterized in that** each of said reinforcement elements (25) consists of a bent sheet disposed astride the respective edge of said conveyor belt (17), said bent sheet having opposite edges welded to said second outer layer (22).

9. Apparatus as in claim 7, **characterized in that** each of said reinforcement elements (25) consists of a bent sheet disposed astride the respective edge of said conveyor belt (17) and attached to said conveyor belt (17) by means of a plurality of studs (26) disposed through, both through the edges of said sheet and also through said second outer layer (22) and through said first inner layer (21).

10. Apparatus as in claim 7, **characterized in that** each of said reinforcement elements (25) consists of a bent sheet disposed astride the respective edge of said conveyor belt (17) and having on one outer edge a plurality of teeth (27) able to engage with corresponding toothed wheels, in order to guide and transmit motion to said conveyor belt (17).

11. Apparatus as any claim hereinbefore, **characterized in that** said supporting and suction plane (28) is associated with said conveyor belt (17) at least in correspondence with said printing unit (13) and said drier unit (14).

12. Apparatus as in claim 7, **characterized in that** said supporting and suction plane (28) also comprises two guide seatings (32) able to cooperate with said reinforcement elements (25), in order to guide the linear sliding of said conveyor belt (17), for preventing any lateral oscillations of said conveyor belt (17).

## Patentansprüche

1. Einrichtung zur Herstellung von photovoltaischen Zellen und elektronischen Schaltkreisen, von denen jede bzw. jeder aus zumindest einer Schicht besteht (12), die aus einer oder mehreren flexiblen, sehr dünnen Platten, im Bereich von ungefähr 100 Mikron, aus Isoliermaterial, wie z.B. Silizium-Wafern, gesintertem Aluminium, rohem oder flexiblem Aluminium besteht, auf welche Leiterbahnen (15) gedruckt sind, wobei diese Einrichtung zumindest eine Druckeinheit (13), die mit der Zuführungsleitung ausgerichtet angeordnet ist und die dazu geeignet ist, die Leiterbahnen (15) auf die Schicht (12) durch Sieb- oder Tintenstrahldruck zu drucken, eine Trockeneinheit (14), die dazu geeignet ist, die Leiterbahnen (15) bei einer bestimmten Trockentemperatur zu trocknen, sowie Transportmittel umfasst (17), die dazu geeignet sind, die Schicht (12) zumindest durch die Druckeinheit (13) und durch die Trockeneinheit (14) zu transportieren, **dadurch gekennzeichnet, dass** die Transportmittel ein einziges Förderband (17) umfassen, das zumindest an der Druckeinheit (13) und an der Trockeneinheit (14) angeordnet ist und das dazu geeignet ist, die Schichten (12) in Reihenfolge durch zumindest die Druckeinheit (13) und durch die Trockeneinheit (14) im wesentlichen kontinuierlich zu befördern, ohne die Schichten (12) quer zur Zuführungsleitung bewegen zu müssen, um die photovoltaischen Zellen oder die elektronischen Schaltkreise zu erhalten, wobei das einzige Förderband (17) aus einem porösen Material mit einem Wärmewiderstand besteht, der gleich wie, oder höher als, die Trockentemperatur ist, um keinen bleibenden Verformungen zu unterliegen, dass das poröse Material einen Wärmewiderstand zwischen ungefähr 90°C und ungefähr 300°C aufweist, und dass das poröse Material aus einer ersten inneren Verstärkungsschicht (21) aus einem Fasergewebe und aus einer zweiten äußeren Schicht (22) aus einem Polymer auf Fluorkohlenstoffbasis besteht, wobei die Druckeinheit (13) ferner eine Auflage- und Absaugebene (28) umfasst, die in Zusammenwirkung mit dem Förderband (17) angeordnet ist, so dass das Förderband (17) im wesentlichen eben gehalten wird, wobei die Auflage- und Absaugebene (28) auch mit einer Vielzahl von Durchgangslöchern versehen ist, die dazu geeignet sind, eine Saugwirkung auszuüben, die durch Ausnutzung der porösen Eigenschaften des Materials, aus dem das Förderband (17) besteht, es ermöglicht, die Schicht (12) an der Außenfläche des Förderbands (17) vollkommen anhaftend zu halten.

2. Einrichtung nach Anspruch 1, **dadurch gekennzeichnet, dass** das Fasergewebe zumindest teilweise auf Siliziumbasis ausgeführt ist.

3. Einrichtung nach Anspruch 1 oder 2, **dadurch gekennzeichnet, dass** das Fasergewebe zumindest teilweise auf organischer Polyamidbasis mit aromatischer Kette ausgeführt ist.

4. Einrichtung nach einem der vorhergehenden Ansprüche, **dadurch gekennzeichnet, dass** das Polymer auf Fluorkohlenstoffbasis Polytetrafluorethylen ist.

5. Einrichtung nach einem der vorhergehenden Ansprüche, **dadurch gekennzeichnet, dass** das Förderband (17) als einziger geschlossener Ring ausgebildet ist, der um eine erste, der Druckeinheit (13) vorgelagerte, angetriebene Riemenscheibe herum (18) und um eine zweite, der Trockeneinheit (14) nachgelagerte, motorisierte Riemenscheibe (19) herum angeordnet ist.

6. Einrichtung nach einem der vorhergehenden Ansprüche,
**dadurch gekennzeichnet, dass** sie ferner eine Vielzahl von Bandspannrollen (20) umfasst, die dazu geeignet sind, das Förderband (17) auf einer gewünschten Betriebsspannung zu halten.

7. Einrichtung nach einem der vorhergehenden Ansprüche, **dadurch gekennzeichnet, dass** entlang der beiden Seitenränder des Förderbands (17) jeweils Verstärkungselemente (25) vorgesehen sind, die aus einem widerstandsfähigen organischen Material bestehen und die dazu geeignet sind, das Förderband (17) zu versteifen sowie den Durchlauf des Förderbands (17) durch die Betriebseinheiten (11, 13, 14, 16) zu lenken.

8. Einrichtung nach Anspruch 7, **dadurch gekennzeichnet, dass** jedes von den Verstärkungselementen (25) aus einer gebogenen Platte besteht, die auf dem jeweiligen Rand des Förderbands (17) rittlings angeordnet und mit ihren entgegengesetzten Rändern an der zweiten äußeren Schicht (22) geschweißt ist.

9. Einrichtung nach Anspruch 7, **dadurch gekennzeichnet, dass** jedes von den Verstärkungselementen (25) aus einer gebogenen Platte besteht, die auf dem jeweiligen Rand des Förderbands (17) rittlings angeordnet und an dem Förderband (17) mittels einer Vielzahl von Stiftbolzen (26) befestigt ist, die sowohl durch die Ränder der Platte als auch durch die zweite äußere Schicht (22), sowie durch die erste innere Schicht (21) durchgehend angeordnet sind.

10. Einrichtung nach Anspruch 7, **dadurch gekennzeichnet, dass** jedes von den Verstärkungselementen (25) aus einer gebogenen Platte besteht, die auf dem jeweiligen Rand des Förderbands (17) rittlings angeordnet ist und an einem äußeren Rand eine Vielzahl von Zähnen (27) aufweist, die dazu geeignet sind, mit entsprechenden Zahnrädern einzugreifen, um das Förderband (17) zu lenken und ihm die Bewegung zu übertragen.

11. Einrichtung nach einem der vorhergehenden Ansprüche, **dadurch gekennzeichnet, dass** die Auflage- und Absaugebene (28) dem Förderband (17) zumindest an der Druckeinheit (13) und an der Trockeneinheit (14) zugeordnet ist.

12. Einrichtung nach Anspruch 7, **dadurch gekennzeichnet, dass** die Auflage- und Absaugebene (28) ferner zwei Führungssitze (32) umfasst, die dazu geeignet sind, mit den Verstärkungselementen (25) zusammenzuwirken, um das lineare Gleiten des Förderbands (17) zu lenken und um seitliche Schwingungen des Förderbands (17) zu verhindern.

## Revendications

1. Appareil pour la production de cellules photovoltaïques et de circuits électroniques, composé d'au moins une couche (12) constituée d'une ou plusieurs feuilles très minces, de l'ordre de 100 micron environ, en matière isolante, par exemple des tranches de silicium, ou en aluminium fritté, brut ou flexible sur lequel sont imprimées des pistes conductives (15), ledit appareil comprenant au moins une unité d'impression (13) alignée avec la ligne d'alimentation et capable d'imprimer lesdites pistes conductives (15) sur ladite couche (12) par sérigraphie ou impression au jet d'encre, une unité de séchage (14) capable de sécher lesdites pistes conductives (15) à une température de séchage donnée, et des moyens de transport (17) capables de transporter ladite couche (12) au moins à travers ladite unité d'impression (13) et ladite unité de séchage (14), **caractérisé en ce que** lesdits moyens de transport comprennent une seule courroie transporteuse (17) disposé au moins en correspondance de ladite unité d'impression (13) et de la dite unité de séchage (14) et capable de transporter, de façon essentiellement continue, les couches en séquence à travers au moins ladite unité d'impression (13) et de ladite unité de séchage (14), sans que les couches (12) doivent être déplacées transversalement à la ligne d'alimentation, pour obtenir les cellules photovoltaïques ou les circuits électroniques, la seule courroie transporteuse étant réalisé en matière poreuse ayant une résistance à la chaleur égale ou supérieure à ladite température de séchage, pour ne pas être exposé à des déformations permanentes , **en ce que** ladite matière poreuse a une résistance à la chaleur comprise entre 90°C environ et 300°C environ, et **en ce que** ladite matière poreuse est constituée d'une première couche de renforcement intérieure (21) en tissu fibreux, et d'au moins une deuxième couche extérieure (22) réalisée en polymère avec une base fluorée, dans lequel l'unité d'impression (13) comprend également une plaque de support et de succion (28), disposée en coopération avec la courroie transporteuse (17), de manière à maintenir la courroie transporteuse (17) essentiellement plane, la plaque de support et de succion (28) ayant également une pluralité de trous passants (30), capables d'assurer une succion qui, grâce aux caractéristiques de porosité de la matière formant la courroie transporteuse (17), permet de maintenir la couche (12) parfaitement adhérente à la surface extérieure de la courroie transporteuse (17).

2. Appareil selon la revendication 1,
**caractérisé en ce que** ledit tissu fibreux est au moins partiellement à base de silicium.

3. Appareil selon la revendication 1 ou 2, **caractérisé en ce que** ledit tissu fibreux est au moins partiellement à base organique polyamide ayant une chaîne aromatique.

4. Appareil selon n'importe quelle revendication précédente, **caractérisée en ce que** ledit polymère avec la base fluorée est polytétrafluoroéthylène.

5. Appareil selon n'importe quelle revendication précédente, **caractérisé en ce que** ladite courroie transporteuse (17) est constitué d'une seule boucle appliquée autour d'une première poulie attaquée (18) située en amont de ladite unité d'impression (13) et une deuxième poulie motorisée (19) située en aval de ladite unité de séchage.

6. Appareil selon n'importe quelle revendication précédente, **caractérisée en ce qu'**il comprend également une pluralité de poulies tendeuse de courroie (20) capables de maintenir ladite courroie transporteuse (17) à une tension de travail désirée.

7. Appareil selon n'importe quelle revendication précédente, **caractérisée en ce que** les deux bords latéraux de ladite courroie transporteuse (17) sont pourvus de respectifs éléments de renforcement (25) en matière organique résistante et capables de rigidifier ladite courroie transporteuse (17) et de guider le passage de ladite courroie transporteuse (17) en correspondance desdites unités opérationnelles (11, 13, 14, 16).

8. Appareil selon la revendication 7,
**caractérisé en ce que** chacun desdits éléments de renforcement (25) est constitué d'une feuille pliée, disposée à califourchon sur le bord correspondant de ladite courroie transporteuse (17), ladite feuille pliée ayant ses bords opposés soudés à ladite deuxième couche extérieure (22).

9. Appareil selon la revendication 7,
**caractérisé en ce que** chacun desdits éléments de renforcement (25) est constitué d'une feuille pliée, disposée à califourchon sur le bord correspondant de ladite courroie transporteuse (17), et fixée à ladite courroie transporteuse au moyen d'une pluralité de goujons (26) perçant les bords de ladite feuille, aussi bien que ladite deuxième couche extérieure (22) et ladite première couche intérieure (21).

10. Appareil selon la revendication 7,
**caractérisé en ce que** chacun desdits éléments de renforcement (25) est constitué d'une feuille pliée, disposée à califourchon sur le bord correspondant de ladite courroie transporteuse (17), et ayant une pluralité de dents (27) sur un bord extérieur, qui sont engageables avec des roues dentées correspondantes, pour guider et transmettre le mouvement à ladite courroie transporteuse (17).

11. Appareil selon n'importe quelle revendication précédente, **caractérisé en ce que** ladite plaque de support et succion (28) est associée à ladite courroie transporteuse (17) au moins en correspondance avec ladite unité d'impression (13) et ladite unité de séchage (14).

12. Appareil selon la revendication 7,
**caractérisé en ce que** ladite plaque de support et de succion (26) comprend également deux sièges (32) capables de coopérer avec lesdits éléments de renforcement (25) pour guider le glissement de ladite courroie transporteuse (17) de manière à empêcher toute oscillation latérale de ladite courroie transporteuse (17).
